(19) Europäisches Patentamt
European Patent Office
Office européen des brevets

(11) **EP 4 430 969 A1**

(12) **EUROPEAN PATENT APPLICATION**
published in accordance with Art. 153(4) EPC

(43) Date of publication:
**18.09.2024 Bulletin 2024/38**

(21) Application number: **22909850.4**

(22) Date of filing: **14.12.2022**

(51) International Patent Classification (IPC):
**A24F 40/40** (2020.01)   **A24F 40/46** (2020.01)
**H05B 3/10** (2006.01)   **C23C 8/00** (2006.01)
**C23C 14/48** (2006.01)

(52) Cooperative Patent Classification (CPC):
**A24F 40/40; A24F 40/42; A24F 40/46;**
**A24F 40/465; A24F 40/57; A24F 40/90; C23C 8/00;**
**C23C 14/48; H05B 3/10;** Y02E 60/10

(86) International application number:
**PCT/CN2022/139097**

(87) International publication number:
**WO 2023/116536 (29.06.2023 Gazette 2023/26)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **21.12.2021 CN 202111569268**

(71) Applicant: **Shenzhen First Union Technology Co.,**
**Ltd.**
**Shenzhen, Guangdong 518000 (CN)**

(72) Inventors:
• **LUO, Jiamao**
**Shenzhen, Guangdong 518000 (CN)**
• **XU, Zhongli**
**Shenzhen, Guangdong 518000 (CN)**
• **LI, Yonghai**
**Shenzhen, Guangdong 518000 (CN)**

(74) Representative: **Jacob, Reuben Ellis et al**
**Maucher Jenkins**
**Seventh Floor Offices**
**Artillery House**
**11-19 Artillery Row**
**London SW1P 1RT (GB)**

(54) **HEATING ASSEMBLY AND AEROSOL GENERATING DEVICE**

(57)    A heating assembly (2) and an aerosol generating device are provided. The heating assembly includes a substrate (21) made of metal, where the substrate (21) is a thermal radiation element configured to radiate heat to heat an inhalable product (1), to cause the inhalable product (1) to generate an aerosol. The substrate (21) is doped with a non-metal element, along a depth direction with a radiating surface of the substrate (21) as a starting point, a distribution density of the non-metal element at a first depth is greater than a distribution density of the non-metal element at a second depth, and the second depth is greater than the first depth. The substrate (21) made of metal has a non-metal element in a surface layer of a certain thickness. The surface layer of the metal substrate (21) is modified by using the non-metal element, so that a thermal radiation emissivity of the metal substrate (21) is increased. Moreover, the surface layer of the metal substrate (21) modified by the non-metal element has an appropriate thermal conductivity, thereby having a good soaking effect, and has high wear resistance and does not fall off.

FIG. 3

## Description

This application claims priority to Chinese Patent Application No. 202111569268.3, filed with the China National Intellectual Property Administration on December 21, 2021 and entitled "HEATING ASSEMBLY AND AEROSOL GENERATING DEVICE", which is incorporated herein by reference in its entirety.

## TECHNICAL FIELD

Embodiments of this application relate to the field of aerosol generating technologies, and in particular, to a heating assembly and an aerosol generating device.

## BACKGROUND

An aerosol generating device uses a heating body therein to heat an inhalable product to generate an aerosol for inhalation. An existing heating body is configured to be inserted into the inhalable product, to heat the inhalable product through a thermal radiation manner from a center of the inhalable product. Some existing heating bodies configured for central heating are made of metal. However, a thermal radiation emissivity of the metal is low, causing low efficiency of a metal heating body in heating the inhalable product through thermal radiation. This leads to a less vapor volume and fragrance of the inhalable product during inhalation, and a taste is affected.

To resolve the problem of the low thermal radiation emissivity of the metal heating body, a high-radiation coating is usually prepared on a surface of the metal heating body. However, currently, the high-radiation coating prepared through a spraying or coating process does not form an integral structure with a metal substrate. Due to a difference in thermal expansion coefficients of the two materials, especially when being subjected to thermal stress during cyclic cold and hot shock, the high-radiation coating is easy to fall off.

Taking a low-temperature spray cured silicone as an example, a thermal expansion coefficient of silicon oxide is approximately $0.5 \times 10^{-6}$, and a thermal expansion coefficient of a commonly used metal material such as an iron-based alloy is approximately $10 \times 10^{-6}$. A difference between the thermal expansion coefficients of the two materials reaches twenty times. During working of the metal heating body, there is large thermal stress on a combination surface of the two materials, and under cyclic cold and hot shock, the coating has a high risk of falling off.

## SUMMARY

Embodiments of this application provide a heating assembly and an aerosol generating device, so that a metal substrate has a high thermal radiation emissivity and does not have a risk of falling off of a coating.

An embodiment of this application provides a heating assembly, including a substrate made of metal, where the substrate is a thermal radiation element configured to radiate heat to heat an inhalable product, to cause the inhalable product to generate an aerosol. The substrate is doped with a non-metal element, along a depth direction with a radiating surface of the substrate as a starting point, a distribution density of the non-metal element at a first depth is greater than a distribution density of the non-metal element at a second depth, and the second depth is greater than the first depth.

An embodiment of this application provides an aerosol generating device, including the heating assembly, and further including: an accommodating cavity, configured to accommodate at least part of an inhalable product;

a battery assembly, electrically connected to the heating assembly, to supply power to heat generating by the heating assembly; and
an installation portion, located below the accommodating cavity, where an end of the substrate is fixed to the installation portion, and an other end of the substrate extends upward into the accommodating cavity.

In the foregoing heating assembly and the aerosol generating device, a substrate made of metal has a non-metal element in a surface layer of a certain depth along a depth direction. The non-metal element is used to modify the surface layer of the metal substrate, so that a thermal radiation emissivity of the metal substrate is improved, the emissivity of the metal substrate may be up to 0.95, and a radiation heating effect of the metal substrate is significantly improved. Moreover, the surface layer of the metal substrate modified by the non-metal element has an appropriate thermal conductivity, so that a good soaking effect is achieved, the temperature evenness on a surface of the substrate can be significantly improved, and an inhalable product can be evenly heated. In addition, the surface layer of the metal substrate having the non-metal element has a very small friction coefficient after being modified by the non-metal element, which is convenient for insertion and removal of the inhalable product, so that the surface layer of the metal substrate having the non-metal element has high wear resistance and does not fall off. The non-metal element is located inside the metal substrate, so that a dose and a concentration of the non-metal element do not affect an outer diameter or a thickness of the metal substrate.

## BRIEF DESCRIPTION OF THE DRAWINGS

One or more embodiments are exemplarily described with reference to the corresponding figures in the accompanying drawings, and the descriptions do not constitute a limitation to the embodiments. Components in the accompanying drawings that have same reference numerals are represented as similar components, and unless otherwise particularly stated, the figures in the accompanying drawings are not drawn to scale.

FIG. 1 is a schematic diagram of an aerosol generating device according to an embodiment of this application;
FIG. 2 is a schematic diagram of a heating assembly according to an embodiment of this application;
FIG. 3 is a cross-sectional view of a heating assembly according to an embodiment of this application;
FIG. 4 is a schematic diagram of an element injection layer and a non-element injection layer in a heating assembly under a microscope according to an embodiment of this application; and
FIG. 5 is a schematic diagram of an existing coating under a microscope according to an embodiment of this application.

In the accompanying drawings:

1. Inhalable product; 11. Aerosol substrate;
2. Heating assembly; 21. Substrate; 211. Element injection layer; 212. Non-element injection layer; 22. Base; 23. Tapered guide portion;
3. Accommodating cavity;
4. Battery assembly;
5. Non-metal element;
6. Inductance coil;
7. Holder; and 8. Installation portion.

## DETAILED DESCRIPTION

The technical solutions in the embodiments of this application are clearly and completely described below with reference to the accompanying drawings in the embodiments of this application. Apparently, the described embodiments are merely some rather than all of the embodiments of this application. All other embodiments obtained by a person of ordinary skill in the art based on the embodiments of this application without creative efforts shall fall within the protection scope of this application.

The terms such as "first", "second", and "third" used in this application are only for the purpose of description, and should not be understood as indicating or implying relative importance or implicitly specifying a quantity or a sequence of indicated technical features. All directional indications (such as up, down, left, right, front, back...) in the embodiments of this application are merely used to explain a relative positional relationship or a motion situation between components in a specific posture (as shown in the accompanying drawings). If the specific posture changes, the directional indication changes correspondingly. In addition, the terms "include", "have", and any variant thereof are intended to cover non-exclusive inclusion.

For example, a process, method, system, product, or device that includes a series of steps or units is not limited to the listed steps or units, but further optionally includes steps or units that are not listed, or further optionally includes other steps or units that are intrinsic to the process, method, product, or device.

"Embodiment" mentioned in the specification means that particular features, structures, or characteristics described with reference to the embodiment may be included in at least one embodiment of this application. The phrase appearing in various positions in the specification does not necessarily refer to the same embodiment, nor an independent or alternative embodiment that is mutually exclusive with another embodiment. A person skilled in the art explicitly or implicitly understands that the embodiments described in the specification may be combined with other embodiments.

It should be noted that, when a component is referred to as "being fixed to" another component, the component may be directly on the another component, or an intervening component may be present. When a component is considered to be "connected to" another component, the component may be directly connected to the another component, or one or more intervening components may also be present among them. The terms "vertical", "horizontal", "left", "right", and similar expressions used in this specification are merely used for an illustrative purpose and do not represent a unique implementation.

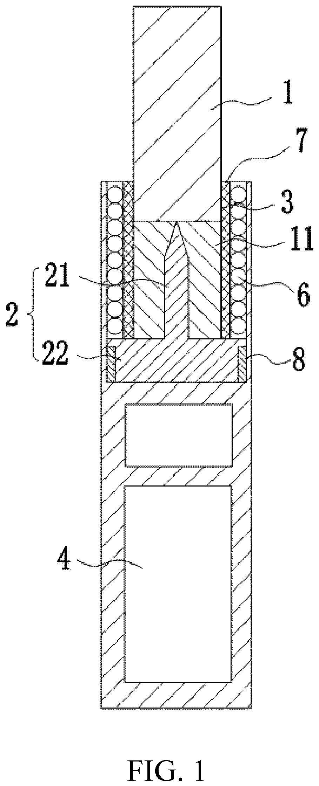

An embodiment of this application provides an aerosol generating device. The device may be configured to heat an aerosol substrate 11 in an inhalable product 1, to make the aerosol substrate 11 to generate an aerosol through volatilization for inhalation. The aerosol may include an herbal medicine, nicotine, or a flavor compound such as tobacco flavor. In the embodiment shown in FIG. 1, the inhalable product 1 is a tobacco product (such as a cigarette or a cigar), but this is not limited herein.

In the embodiment shown in FIG. 1, the aerosol generating device includes a heating assembly 2, an accommodating cavity 3, and a battery assembly 4.

The accommodating cavity 3 is configured to accommodate at least part of the inhalable product 1, and at least part of the heating assembly 2 is arranged in the accommodating cavity 3, so that the at least part of the heating assembly 2 may be inserted into the inhalable product 1, and radiate heat to the inhalable product 1 through heating or thermal transmission, so as to heat the inhalable product 1 to generate the aerosol. The battery assembly 4 is electronically connected to the heating assembly 2, to provide electric energy required for the heating assembly 2 to radiate heat. The accommodating cavity 3 is removably connected to the inhalable product 1, so that the inhalable product 1 may be replaced.

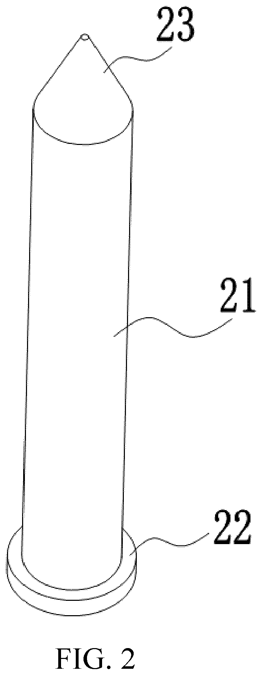

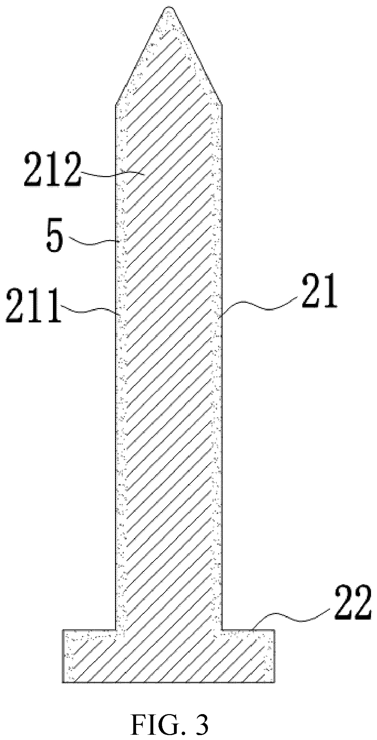

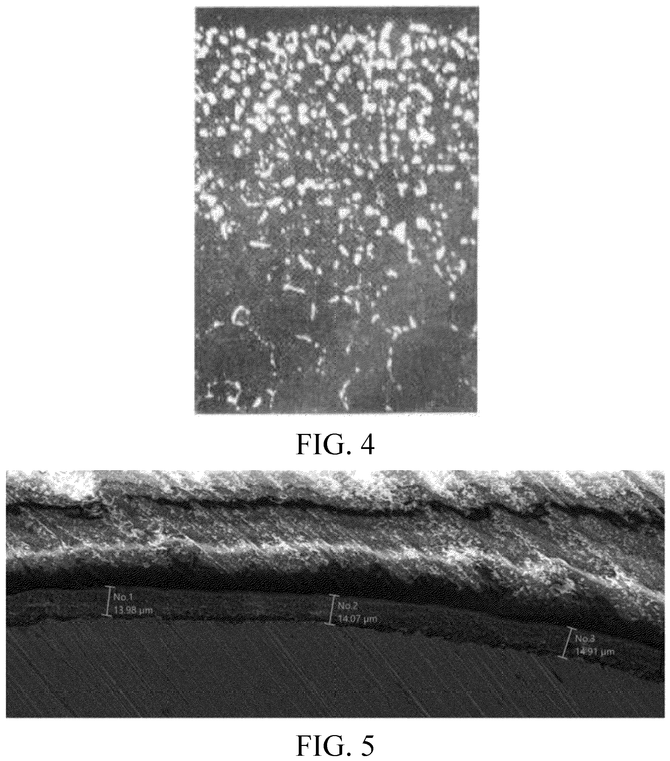

Referring to FIG. 2, the heating assembly 2 includes a substrate 21. The substrate 21 is a columnar structure, a sheet structure, or a cylindrical structure made of metal. An inside of the substrate may be solid or hollow, or may be partially solid and partially hollow. An outer contour of a cross section of the substrate may be in a symmetrical or asymmetric shape, such as a circle, an ellipse, a straight line, a cross, a starburst, or the like. At least part of the substrate 21 may be configured to be inserted into the inhalable product 1. After being inserted into the inhalable product 1, the substrate 21 may be in direct contact with the inhalable product 1. In this case, a surface of the substrate 21 facing the inhalable product 1 is an outer surface of the substrate 21, that is, a radiating surface of the substrate 21, and heat is emitted toward the inhalable product 1 through the radiating surface. Referring to FIG. 3 and FIG. 4, the substrate 21 has a non-metal element 5 and a metal element (a metal atom or a metal ion) that forms the substrate 21. The non-metal element 5 may be one or more of carbon, nitrogen, boron, or phosphorus. The non-metal element 5 is used to improve a metal surface layer, to increase a thermal radiation emissivity of a metal radiating surface, so that the inhalable product 1 can be more efficiently and evenly baked. At the same heating power, a vapor volume and fragrance generated per unit time by the inhalable product 1 may be significantly increased, improving an inhalation taste to a great extent. In addition, the non-metal element 5 can reduce a friction coefficient of the metal radiating surface, making it convenient for insertion and removal of the inhalable product 1.

Referring to FIG. 3 and FIG. 4, along a depth direction with the radiating surface as a starting point, a distribution density of the non-metal element 5 varies at different depths in the substrate 21. A distribution density at a greater depth (such as a second depth) is less than a distribution density at a smaller depth (such as a first depth). Therefore, the non-metal element 5 is mainly used to modify a surface layer of the substrate 21 with the radiating surface as a starting point. This does not affect an original property and function of the substrate 21 at a large depth from the radiating surface, or has small impact on an original property and function of the substrate 21 at a large depth from the radiating surface. For example, this does not affect resistance or the like of the substrate 21 at a large depth from the radiating surface, or has small impact on resistance or the like of the substrate at a large depth from the radiating surface, so that normal working of the substrate 21 is not affected.

In some embodiments, along the depth direction with the radiating surface of the substrate 21 as the starting point, the non-metal element 5 is distributed in the substrate 21 in a decreasing distribution density manner. The decreasing distribution density manner includes a regular decreasing manner such as decreasing in an arithmetic progression or decreasing in a geometric progression, or another irregular decreasing manner.

In some embodiments, the non-metal element 5 may be doped into the substrate 21 through ion injection. By controlling injected energy and an injected dose of the non-metal element 5, an injection concentration and depth of the non-metal element 5 may be precisely adjusted. Density distribution N(x) of the injected non-metal element 5 along an injection depth x may be calculated by using the following formula:

$$N(x) = \frac{\Phi t}{\sqrt{2\pi}\Delta R_P} e^{-\frac{1}{2}\left(\frac{x-R_P}{\Delta R_P}\right)^2}$$

In the formula, $\Delta R_P$ is a projected range, $R_P$ is a standard deviation, $\Phi t$ is an injected dose (a number of non-metal elements 5 injected per unit area). The formula shows that, with other conditions remain unchanged, the distribution density has a linear relationship with the injected dose of the non-metal element 5. For the substrate 21 made of metal, a greater dose of the injected non-metal element 5 indicates a higher intensity, and a better surface modification effect. Different from thermal diffusion, by using the ion injection manner to make the substrate 21 has the non-metal element 5 inside, a depth and a density of the non-metal element 5 distributed inside the substrate 21 may be precisely controlled. Compared with a conventional manner of forming a coating or film formed on a surface of the substrate through chemical vapor deposition (APCVD), vacuum evaporation, sputtering, conventional CVD, plasma CVD, or flame pyrolysis, after the non-metal element 5 is injected into the substrate 21, the non-metal element 5 can be organically combined with the metal substrate 21, and may be combined with a metal element in the metal substrate 21 to precipitate dispersed phases and superhard phases of carbide, nitride, boride, phosphide, and the like. In this way, the surface hardness and elastic modulus of the substrate 21 can be significantly improved, and there is no clear or strict boundary between a distribution area and a non-distribution area of the non-metal element 5 injected in the substrate 21, so that the film or coating does not fall off. Certainly, it is not excluded that the non-metal element 5 may alternatively be doped into the substrate 21 through another manner, such as thermal diffusion.

In some embodiments, referring to FIG. 3 and FIG. 4, an element injection layer 211 and a non-element injection layer 212 are formed in the substrate 21. The non-metal element 5 is distributed in the element injection layer 211 through ion injection, and the non-metal element 5 doped through ion injection is not distributed in the non-element injection layer 212 (the non-element injection layer 212 may be doped with the non-metal element 5 because metal is not purified or may be doped with the non-metal element 5 during forging, but a doping amount per unit volume is small and is far less than the amount of the non-metal element 5 doped on the surface of the metal substrate 21 through ion injection, so that the doped non-metal ion may be ignored). In a critical region between the element injection layer 211 and the non-element injection layer 212, since the injected non-metal element 5 (such as a non-metal ion) collides with an original metal element (such as a metal atom) in the metal substrate 21 and/or a later injected non-metal ion, the injected non-metal element 5 eventually exhaust energy and stays at different depths of the metal substrate 21 according to different energy during injection of the non-metal element and different types of collisions occurring after the injection (an elastic collision or an inelastic collision, a collision with an element having a large mass, a collision with an element having a small mass, or the like). An injection depth of some non-metal elements 5 is large, while an injection depth of some non-metal elements 5 is small, making a blurred boundary between the element injection layer 211 and the non-element injection layer 212. The non-metal element 5 doped through ion injection may enter a crystal lattice of the original metal element (the metal atom) in the substrate 21 or replace a position of the original metal element in the crystal lattice to shift a position of the original metal element, so that the injected non-metal element 5 is combined with the original metal element in the substrate 21 through an acting force between atoms or ions to form a stable structure. In the critical region, the element injection layer 211 and the non-element injection layer 212 penetrate and blend with each other, and there is no clear or obvious boundary, or the boundary is not clear. In a field of view of a microscope, as shown in FIG. 4, the boundary between the element injection layer 211 (the white dots in the figure are the non-metal elements 5) and the non-element injection layer 212 is blurred, and there is no obvious boundary. If a coating or film is formed on the surface of the substrate 21 through chemical vapor deposition (APCVD), vacuum evaporation, sputtering, conventional CVD, plasma CVD, or flame pyrolysis, a boundary can be clearly seen in a whole formed by the substrate 21 and the coating or the film under a microscope, as shown in FIG. 5. Therefore, in this embodiment, since elements in the element injection layer 211 and the non-element injection layer 212 penetrate and blend with each other in the critical region, and the non-metal element 5 is combined with the metal element originally existing in the substrate 21 through an acting force between atoms or ions, the two materials do not separate from each other under cyclic cold and hot shock due to different thermal expansion coefficients, so that the element injection layer 211 does not fall off or peel off from the non-element injection layer 212.

An example in which the non-metal element 5 is carbon is used, a carbon element (such as carbon ion) beam may be accelerated in vacuum at a low temperature. The carbon element beam is incident into the metal substrate 21, and physically and/or chemically reacts with the metal atom in the metal substrate 21, until the energy is consumed, the carbon element beam no longer goes deep, and stays and remains in the metal substrate 21. It is tested through experiments that, after the carbon element is injected into the surface layer of the metal substrate 21 through ion injection and the element injection layer 211 is formed on the surface of the metal substrate 21, the thermal radiation emissivity on the surface of the metal substrate 21 is approximately 0.95 (a thermal radiation emissivity of ceramic such as aluminum oxide or zirconia ranges from 0.9 to 0.95), so that a thermal radiation heating effect of the metal substrate 21 is significantly improved, reaching or even exceeding the thermal radiation emissivity of a ceramic housing. In addition, a thermal conductivity of the carbon element is approximately 129 W/(mK). When the element injection layer 211 of the metal substrate 21 is a carbon element injection layer, a surface of the metal substrate has a good soaking effect, and the temperature evenness on the surface of the metal substrate 21 can be significantly improved. In addition, the carbon element has good lubrication performance, so that a friction coefficient of the surface of the metal substrate 21 can be reduced, and the wear resistance and anti-stick performance of the metal substrate 21 can be improved. Moreover, the carbon element penetrates into the metal substrate 21 and enters the crystal lattice of the metal atom in the metal substrate 21, so that a thickness and an outer diameter of the metal substrate 21 are not increased, and the carbon element does not fall off from the metal substrate 21.

The element injection layer 211 is formed inside the metal substrate 21, and is not the coating or the film adhered to the surface of the metal substrate 21, so there is no risk of falling off.

In some embodiments, the substrate 21 may generate heat, and the generated heat is used for heating or baking the inhalable product 1. The substrate 21 is an electric heating element, and a heating manner thereof includes resistance heating (a metal forming the substrate 21 has high resistance, such as nickel-chromium alloy and other alloy metal, or a structure of the substrate has high resistance, such as a MESH or a metal etching sheet, so that the substrate 21 may generate heat through resistance when energized), electromagnetic heating, and the like.

Details are described below by taking an example in which the substrate 21 generates heat through electromagnetic heating.

The substrate 21 is made of a metallic magnetic body that may generate heat in a variable magnetic field. When the variable magnetic field is applied to the magnetic body, the magnetic body generates an energy loss caused by an eddy current loss and a hysteresis loss, and the lost energy is released from the magnetic body as thermal energy. A greater amplitude or frequency of the variable magnetic field applied to the magnetic body indicates more thermal energy released from the magnetic body. The magnetic body may include at least one of ferrite, ferromagnetic alloy, stainless steel, or aluminum (Al). In addition, the magnetic body may further include at least one of molybdenum, niobium, nickel alloy, a metal film, nickel (Ni), or cobalt (Co).

Referring to FIG. 1, for the case that the substrate 21 heats the inhalable product 1 through electromagnetic heating, the aerosol generating device further includes an inductance coil 6, where the inductance coil 6 is configured to generate the variable magnetic field. The heating assembly 2 is arranged within a range of the variable magnetic field generated by the inductance coil 6, so that when the inductance coil 6 is energized to work, the substrate 21 may generate heat. Referring to FIG. 1, the inductance coil 6 may be arranged at a periphery of the substrate 21, and is spaced apart from the substrate 21. The inductance coil 6 may alternatively be arranged in the substrate 21. In this case, the substrate 21 has a cavity inside to accommodate the inductance coil 6. The inductance coil 6 is connected to an inner wall of the substrate 21 through an insulating layer in the cavity, or the inductance coil 6 is not in contact with the inner wall of the substrate 21 in the cavity.

In a specific embodiment, the inductance coil 6 is in a cylindrical shape wound into a spiral shape, and has a radius r ranging from approximately 5 mm to approximately 10 mm. The substrate 21 is arranged inside the inductance coil 6 and is surrounded by the inductance coil 6. A length of the cylindrical inductance coil 6 wound into a spiral shape may range from approximately 8 mm to approximately 14 mm, and a number of turns of the inductance coil 6 ranges from approximately 8 to 15. Correspondingly, an inner volume of the inductance coil 6 may range from approximately $0.15\,cm^3$ to approximately $1.10\,cm^3$. In a more preferred implementation, a frequency of an alternating current supplied by the battery assembly 4 to the inductance coil 6 ranges from 80 KHz to 400 KHz; and more specifically, the frequency may range from approximately 200 KHz to 300 KHz.

The substrate 21 forms an eddy current (an induced current) in the variable magnetic field, so as to generate heat. The eddy current generated through electromagnetic induction has a skin effect, so the induced current in the substrate 21 is mainly concentrated on the surface layer with a large amount of non-metal elements 5. Content of the non-metal element 5 in the substrate 21 affects a conductivity of the substrate 21. Specifically, more non-metal elements in metal indicates a higher resistivity of the metal, higher resistance, and higher heating efficiency at a same current. Therefore, the injected non-metal element 5 may greatly improve the heating efficiency of the surface layer of the substrate 21, and a temperature of the surface layer of the substrate 21 can be greatly improved, so that the radiating surface of the substrate 21 can radiate more heat outward per unit time, and the inhalable product 1 is more thoroughly heated.

Referring to FIG. 1, the aerosol generating device includes a holder 7 and an installation portion 8. The installation portion 8 is fixed inside of the holder 7 and located below the accommodating cavity 3. The accommodating cavity 3 is located in the holder 7. An upper end of the accommodating cavity 3 is open for insertion of the inhalable product 1. The inductance coil 6 is wound in a spiral shape around an outer side of the holder 7. The inductance coil 6 is located at a periphery of the substrate 21, so that when the inductance coil 6 generates a variable magnetic field, the substrate 21 has high heating efficiency since the substrate has large magnetic flux and a large magnetic flux change rate.

Referring to FIG. 2 and FIG. 3, the heating assembly 2 further includes a base 22, where the base 22 is connected to the substrate 21. Functions of the base 22 include: 1. The base serves as a flange of the substrate 21 to connect the substrate 21 to the installation portion 8, so that the substrate 21 is fixed to the holder 7; and 2. The base 22 is made of the same metal as the substrate 21, may generate heat synchronously with the substrate 21, and may have the same heating efficiency as the substrate 21. A surface of the base may also have the element injection layer 211, and a type, a dose, and a concentration of elements injected in the element injection layer 211 may be the same as the type, the dose, and the concentration of the elements in the element injection layer on the substrate 21. When the substrate 21 is inserted into the inhalable product 1, the base 22 is exposed outside the inhalable product 1. Therefore, the base 22 can be connected to a thermocouple or another temperature detector, so that the thermocouple or the another temperature detector can indirectly detect a heating temperature of the substrate 21 by detecting a heating temperature of the base 22. The thermocouple or the temperature detector is connected to the base 22 instead of being directly connected to the substrate 21. In this way, the substrate 21 is completely solid, thereby ensuring an even thickness and an even temperature field of the substrate 21, and the surface of the substrate 21 may be complete and smooth rather than being uneven due to connection to the thermocouple or the temperature detector, so that insertion or removal of the substrate into or from the inhalable product 1 is not affected. The thermocouple or the temperature detector may be connected to a bottom surface (a surface opposite to an installation surface of the substrate 21) of the base 22, but this is not limited. In some embodiments, the metal forming the base 22 and the metal forming the substrate 21 are both metal materials (including alloy) with high resistance. The base 22 and the substrate 21 generate heat through resistance. An element that connects the battery assembly 4 to the heating assembly 2 is a wire or an electrode. The wire or the electrode may be electrically connected to the base 22 to supply power for heat generating by the substrate 21. In some embodiments, the metal forming the base 22 and the metal forming the substrate 21 are both magnetic bodies. The base 22 and the substrate 21 generate heat through electromagnetic induction. An element that connects the battery assembly 4 to the heating assembly 2 is a wire or an electrode. The wire or the electrode may be electrically connected to the inductance coil 6 to cause the base 22 and the substrate 21 to generate heat.

In some embodiments, the base 22 is made of an insulating material, and the thermocouple or the temperature detector is connected to the base 21 to detect a temperature of the substrate 21.

Referring to FIG. 2 and FIG. 3, an outer diameter of the base 22 is greater than an outer diameter of the substrate 21, that is, an outer contour of a cross section of the base 22 is greater than an outer contour of a cross section the substrate 21. The substrate 21 is fixed to a central region of the base 22. A fool-proof structure may be arranged on the base 22, to facilitate installation of the heating assembly 2, and prevent the heating assembly 2 from being reversely installed on another object. The base 22 may be integrated with the substrate 21 by casting or injection molding, or may be assembled and connected after separate molding.

Referring to FIG. 2 and FIG. 3, the heating assembly 2 further include a tapered guide portion 23, where the tapered guide portion 23 is connected to the substrate 21, and at least part of the substrate 21 and the tapered guide portion 23 are configured to be inserted into the inhalable product 1. By arranging the tapered guide portion 23 on an upper end of the substrate 21, the substrate 21 may be conveniently inserted into the inhalable product 1. In some embodiments, the tapered guide portion 23 is made of metal, and is a solid structure or has a cavity inside. The metal has a high thermal conductivity, so that a temperature of the tapered guide portion 23 can be basically kept consistent with the temperature of the substrate 21, reducing a temperature gradient between the tapered guide portion 23 and the substrate 21. Besides, the tapered guide portion 23 may be electrically connected to the substrate 21, so that the tapered guide portion 23 and the substrate 21 may generate heat synchronously, and the baking adequacy of the inhalable product 1 can be further improved. To further ensure the heat generating consistency between the tapered guide portion 23 and the substrate 21, the tapered guide portion 23 may also be doped with the non-metal element 5 through ion injection or another manner. A type, energy, and a dose of the non-metal element 5 in the tapered guide portion 23 may be all consistent with those of the non-metal element 5 in the substrate 21. Therefore, a distribution density and a distribution manner of the non-metal element 5 in the tapered guide portion 23 may also be substantially consistent with the distribution density and the distribution manner of the non-metal element 5 in the substrate. Further, the tapered guide portion 23 and the substrate 21 may be made of the same metal material, such as magnetic metal, so that the tapered guide portion 23 may also generate heat in the variable magnetic field.

In some embodiments, as shown in FIG. 3, an overall surface layer of the substrate 21 is doped with the non-metal element 5. In some other embodiments, only part of the surface layer of the substrate is doped with the non-metal element. Specifically, the substrate 21 includes a first section and a second section. At least part of the second section is connected to the installation portion 8, so that the substrate 21 is fixed to the installation portion 8. The first section is configured to be inserted into the inhalable product 1, and the second section is exposed to the outside when the first section is inserted into the inhalable product 1, that is, the second section cannot be inserted into the inhalable product 1, or the second section does not need to be inserted into the inhalable product 1. A surface layer of the first section is doped with the non-metal element 5, and a doping manner includes ion injection and the like. A surface layer of the second section is not doped with the non-metal element 5 through ion injection, or content of the non-metal element 5 in the surface layer of the second section is far less than content of the non-metal element 5 in the surface layer of the first section. Therefore, the non-metal element 5 only modifies a surface of the first section, making the surface of the first section have a high thermal radiation emissivity and a high strength. Since the second section does not need to be inserted into the inhalable product 1, the second section does not need to be modified, thereby reducing costs. Compared with a surface of the second section, the surface of the first section has a smaller friction coefficient, so that the first section can be more smoothly inserted into and removed from the inhalable product 1.

In some embodiments, the substrate 21 is in a tubular shape running through from top to bottom or in a cylindrical shape with a bottom seal. The inhalable product 1 may be at least partially accommodated in the substrate, so that the substrate 21 can heat the inhalable product inwardly from a periphery of the inhalable product. The non-metal element 5 is injected from an inner surface of the substrate 21, or the non-metal element 5 is injected on a surface of a metal sheet, and then the metal sheet is manufactured into the substrate 21 with a surface layer with high content of the non-metal element 5 inside. That is, in this case, the inner surface of the substrate 21 is a radiating surface of the substrate. The substrate 21 in the tubular shape or in the cylindrical shape with the bottom seal may generate heat through resistance heating, electromagnetic heating, or the like. A heating manner of the substrate is not limited.

In some embodiments, the substrate 21 is a metal housing covering a periphery of a heating body or a heating body is located at the periphery of the substrate 21. When energized, the heating body generates heat and transfers the heat to the substrate 21 through thermal transmission to raise the temperature of the substrate 21, or the heating body emits an infrared ray to the substrate 21 to raise the temperature of the substrate 21. Then the substrate radiates the heat to the inhalable product 1 through the radiating surface of the substrate 21 facing the inhalable product, to further heat or bake the inhalable product 1, causing the inhalable product 1 to generate an aerosol.

In the foregoing heating assembly 2 and the aerosol generating device, a substrate 21 made of metal has a non-metal element 5 in a surface layer of a certain depth along a depth direction. The non-metal element 5 is used to modify the surface layer of the metal substrate 21, so that a thermal radiation emissivity of the metal substrate 21 is improved, the emissivity of the metal substrate may be up to 0.95, and a radiation heating effect of the metal substrate 21 is significantly improved. Moreover, the surface layer of the metal substrate 21 modified by the non-metal element 5 has an appropriate thermal conductivity, so that a good soaking effect is achieved, the temperature evenness on a surface of the substrate 21 can be significantly improved, and an inhalable product 1 can be evenly heated. In addition, the surface layer of the metal substrate 21 having the non-metal element 5 has a very small friction coefficient after being modified by the non-metal element 5, which is convenient for insertion and removal of the inhalable product 1, so that the surface layer of the metal substrate 21 having the non-metal element 5 has high wear resistance and does not fall off. The non-metal element 5 is located inside the metal substrate 21, so that a dose and a concentration of the non-metal element 5 do not affect an outer diameter or a thickness of the metal substrate 21.

It should be noted that, the specification of this application and the accompanying drawings thereof illustrate preferred embodiments of this application, but are not limited to the embodiments described in this specification, furthermore, a person of ordinary skill in the art may make improvements or modifications according to the foregoing description, and all the improvements and modifications shall fall within the protection scope of the appended claims of this application.

**Claims**

1. A heating assembly, comprising a substrate made of metal, wherein the substrate is a thermal radiation element configured to radiate heat to heat an inhalable product, to cause the inhalable product to generate an aerosol, the substrate is doped with a non-metal element, along a depth direction with a radiating surface of the substrate as a starting point, a distribution density of the non-metal element at a first depth is greater than a distribution density of the non-metal element at a second depth, and the second depth is greater than the first depth.

2. The heating assembly according to claim 1, wherein an element injection layer and a non-element injection layer are formed in the substrate, wherein the element injection layer comprises a non-metal element injected through ions and a metal element forming the substrate, and the non-element injection layer comprises the metal element forming the substrate.

3. The heating assembly according to claim 2, wherein the element injection layer and the non-element injection layer blend with each other at a critical region.

4. The heating assembly according to claim 1, wherein along the depth direction with the radiating surface of the substrate as a starting point, the non-metal element is distributed in the substrate in a decreasing distribution density manner.

5. The heating assembly according to claim 2, wherein the non-metal element combines with part of the metal element in the substrate to form a dispersed phase or a superhard phase.

6. The heating assembly according to claim 1, wherein the non-metal element is one or more of carbon, nitrogen, boron, or phosphorus.

7. The heating assembly according to claim 1, wherein the substrate is made of a metallic magnetic body that generates heat in a variable magnetic field.

8. The heating assembly according to claim 1, wherein the heating assembly further comprises a tapered guide portion, the tapered guide portion is connected to the substrate, and at least part of the substrate and the tapered guide portion are configured to be inserted into the inhalable product.

9. The heating assembly according to claim 8, wherein the tapered guide portion is made of metal, and is a solid structure or has a cavity inside.

10. The heating assembly according to claim 9, wherein the tapered guide portion is doped with the non-metal element, and distribution of the non-metal element in the substrate is substantially the same as distribution of the non-metal element in the tapered guide portion.

11. The heating assembly according to claim 1, wherein the substrate is a tubular structure accommodating at least part of the inhalable product, and the radiating surface is an inner surface of the substrate.

12. An aerosol generating device, comprising the heating assembly according to any one of claims 1 to 11, and further comprising:

    an accommodating cavity, configured to accommodate at least part of an inhalable product;
    a battery assembly, electrically connected to the heating assembly, to supply power to heat generating by the heating assembly; and
    an installation portion, located below the accommodating cavity, wherein an end of the substrate is fixed to the installation portion, and an other end of the substrate extends upward into the accommodating cavity.

13. The aerosol generating device according to claim 12, wherein the aerosol generating device further comprises a temperature detector, the heating assembly further comprises a base, the base connects the substrate to the installation portion, and the temperature detector is connected to the substrate.

14. The aerosol generating device according to claim 12, wherein the aerosol generating device further comprises a temperature detector, the heating assembly further comprises a base doped with the non-metal element, the base connects the substrate to the installation portion, the base and a main body portion are made of the same metallic magnetic body, distribution of the non-metal element on the base is substantially the same as distribution of the non-metal element on the substrate, and the temperature detector is connected to the base.

15. The aerosol generating device according to claim 14, wherein the heating assembly comprises an inductance coil arranged at a periphery of the substrate, the aerosol generating device comprises a holder, the accommodating cavity is located in the holder, the installation portion is fixedly connected to the holder, and the inductance coil is wound in a spiral shape around an outer side of the holder.

16. The aerosol generating device according to claim 12, wherein the substrate comprises a first section and a second section, at least part of the second section is connected to the installation portion, the second section is exposed to the outside when the first section is inserted into the inhalable product, and the first section is doped with the non-metal element.

17. The aerosol generating device according to claim 16, wherein a friction coefficient of a surface of the first section is less than a friction coefficient of a surface of the second section.

FIG. 1

FIG. 2

FIG. 3

FIG. 4

FIG. 5

## INTERNATIONAL SEARCH REPORT

| International application No. |
|---|
| **PCT/CN2022/139097** |

**A.    CLASSIFICATION OF SUBJECT MATTER**

A24F40/40(2020.01)i;A24F40/46(2020.01)i;H05B3/10(2006.01)i;C23C8/00(2006.01)i;C23C14/48(2006.01)i

According to International Patent Classification (IPC) or to both national classification and IPC

**B.    FIELDS SEARCHED**

Minimum documentation searched (classification system followed by classification symbols)

IPC: A24F H05B C23C

Documentation searched other than minimum documentation to the extent that such documents are included in the fields searched

Electronic data base consulted during the international search (name of data base and, where practicable, search terms used)

CNABS; CNTXT; ENTXTC; ENTXT; WPABS; VEN: 加热, 发热, 掺杂, 掺入, 注入, 渗, 改性, 金属, 非金属, 渗碳, 渗氮, 渗硼, 渗磷, 碳, 氮, 硼, 磷, 表层, 表面, 离子注入, 热扩散, 固渗, 辐射率, 发射率, 辐射, 发射, 导热, 传热, 均热, 温度, 均匀, 脱落, 剥离, 膨胀, 分离, 开裂, heater?, heated element?, heating element?, heat+, metal+, non-metal+, layer+, surfac+, dop+, modif+, therm+, transfer, diffus+, ion implant+, ionic implant+, emissivity, radiat+, carbur+, nitrid+, bori

**C.    DOCUMENTS CONSIDERED TO BE RELEVANT**

| Category* | Citation of document, with indication, where appropriate, of the relevant passages | Relevant to claim No. |
|---|---|---|
| X | EP 0189210 A2 (CUV "PROGRES") 29 July 1986 (1986-07-29) description, pages 2-4 | 1-11 |
| X | CN 107429394 A (KIRIN CO., LTD.) 01 December 2017 (2017-12-01) description, paragraphs 28-104, and figures 1-5 | 1-11 |
| Y | EP 0189210 A2 (CUV "PROGRES") 29 July 1986 (1986-07-29) description, pages 2-4 | 12-17 |
| Y | CN 107429394 A (KIRIN CO., LTD.) 01 December 2017 (2017-12-01) description, paragraphs 28-104, and figures 1-5 | 12-17 |
| Y | CN 113017149 A (SHENZHEN FIRST UNION TECHNOLOGY CO., LTD.) 25 June 2021 (2021-06-25) description, paragraphs 70-106, and figures 1-11 | 12-17 |
| A | AT A212694 A (PLANSEE AG) 15 December 2000 (2000-12-15) entire document | 1-17 |

☑ Further documents are listed in the continuation of Box C.        ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **14 February 2023** | **17 February 2023** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

**14**

# EP 4 430 969 A1

## INTERNATIONAL SEARCH REPORT

International application No.

**PCT/CN2022/139097**

### C. DOCUMENTS CONSIDERED TO BE RELEVANT

| Category* | Citation of document, with indication, where appropriate, of the relevant passages | Relevant to claim No. |
|---|---|---|
| A | CN 106756758 A (GUANGDONG MIDEA ENVIRONMENT APPLIANCES MANUFACTURING CO., LTD. et al.) 31 May 2017 (2017-05-31) entire document | 1-17 |
| A | CN 109526070 A (SUZHOU IMOTECH MATERIALS TECHNOLOGY CO., LTD.) 26 March 2019 (2019-03-26) entire document | 1-17 |
| A | CN 112244366 A (HUBEI CHINA TOBACCO INDUSTRY CO., LTD.) 22 January 2021 (2021-01-22) entire document | 1-17 |
| A | CN 113755787 A (ULVAC INC.) 07 December 2021 (2021-12-07) entire document | 1-17 |
| A | JP H04367 A (MATSUSHITA ELECTRIC WORKS LTD.) 06 January 1992 (1992-01-06) entire document | 1-17 |
| X | NEJIM, A. et al. "Ion Implantation of Stainless Steel Heater Alloys For Anti-Fouling Applications" *1998 international conference on ion implantation technology proceedings*, 26 June 1998 (1998-06-26), abstract, and pages 869-872 | 1-11 |
| Y | NEJIM, A. et al. "Ion Implantation of Stainless Steel Heater Alloys For Anti-Fouling Applications" *1998 international conference on ion implantation technology proceedings*, 26 June 1998 (1998-06-26), abstract, and pages 869-872 | 12-17 |

Form PCT/ISA/210 (second sheet) (July 2022)

**15**

# EP 4 430 969 A1

## INTERNATIONAL SEARCH REPORT
### Information on patent family members

International application No.

**PCT/CN2022/139097**

| Patent document cited in search report | | | Publication date (day/month/year) | Patent family member(s) | | | Publication date (day/month/year) |
|---|---|---|---|---|---|---|---|
| EP | 0189210 | A2 | 29 July 1986 | EP | 0189210 | A3 | 14 January 1987 |
| | | | | JPS | 61233927 | A | 18 October 1986 |
| | | | | BG | 41748 | A1 | 13 August 1987 |
| CN | 107429394 | A | 01 December 2017 | AU | 2016220723 | A1 | 31 August 2017 |
| | | | | KR | 20170118137 | A | 24 October 2017 |
| | | | | SG | 11201706481 | RA | 28 September 2017 |
| | | | | PH | 12017501437 | A1 | 15 January 2018 |
| | | | | EP | 3260573 | A1 | 27 December 2017 |
| | | | | EP | 3260573 | A4 | 25 July 2018 |
| | | | | EP | 3260573 | B1 | 02 October 2019 |
| | | | | WO | 2016133220 | A1 | 25 August 2016 |
| | | | | TW | 201704519 | A | 01 February 2017 |
| | | | | US | 2018027613 | A1 | 25 January 2018 |
| | | | | JPWO | 2016133220 | A1 | 30 November 2017 |
| | | | | JP | 6731397 | B2 | 29 July 2020 |
| | | | | VN | 54990 | A | 27 November 2017 |
| | | | | SG | 11201706481 | A1 | 28 September 2017 |
| CN | 113017149 | A | 25 June 2021 | EP | 4074197 | A1 | 19 October 2022 |
| | | | | EP | 4074197 | A4 | 18 January 2023 |
| | | | | WO | 2021115339 | A1 | 17 June 2021 |
| AT | A212694 | A | 15 December 2000 | AT | 408049 | B | 27 August 2001 |
| CN | 106756758 | A | 31 May 2017 | None | | | |
| CN | 109526070 | A | 26 March 2019 | CN | 109526070 | B | 03 August 2021 |
| CN | 112244366 | A | 22 January 2021 | CN | 112244366 | B | 19 July 2022 |
| | | | | WO | 2021013146 | A1 | 28 January 2021 |
| CN | 113755787 | A | 07 December 2021 | JP | 2021190333 | A | 13 December 2021 |
| JP | H04367 | A | 06 January 1992 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202111569268